# EUROPÄISCHE PATENTSCHRIFT

(11) **EP 2 980 923 B1**
(45) Veröffentlichungstag und Bekanntmachung des Hinweises auf die Patenterteilung: **15.11.2017**
(21) Anmeldenummer: 14179093.1
(22) Anmeldetag: 30.07.2014
(51) Int. Cl.: H01R 4/64, H05K 7/14, H01R 12/72, H01R 13/6596, H01R 13/504

(54) **Automatisierungsbaugruppe für die industrielle Prozessautomatisierung**
Automation assembly for industrial process automation
Bloc d'automatisation pour l'automatisation industrielle de processus

(43) Veröffentlichungstag der Anmeldung: 03.02.2016
(73) Patentinhaber: Siemens Aktiengesellschaft, 80333 München (DE)
(72) Erfinder: Görlich, Stefan, 92278 Illschwang (DE); Reinhard, Alexander, 92224 Amberg (DE)

(56) Entgegenhaltungen:
- WO-A2-2009/120942
- DE-A1-102012 022 746
- DE-C1- 19 716 137

## Beschreibung

Die Erfindung geht aus von einer Automatisierungsbaugruppe für die industrielle Prozessautomatisierung, umfassend ein Gehäuse mit einem ersten integrierten Befestigungsmittel und einem zweiten integrierten Befestigungsmittel, welche gegenüberliegend angeordnet sind, einen ersten Datenanschluss, einen zweiten Datenanschluss, eine elektronische Leiterplatte, wobei der erste Datenanschluss und der zweite Datenanschluss im Bereich des ersten Befestigungsmittels angeordnet sind.

Für die Datenkommunikation bei Automatisierungsbaugruppen ist es insbesondere im schweren industriellen EMV belasteten Umfeld, notwendig geschirmte Datenleitungen zu verwenden. Diese Datenleitungen werden beispielsweise über Rundsteckverbinder mit den Automatisierungsbaugruppen verbunden. Um eine Schirmanbindung von dem Kabel der Datenleitung über den Rundsteckverbinder zu einer Leiterplatte der Automatisierungsbaugruppe sicher zu stellen, werden nach dem Stand der Technik Metallgehäuse für die Automatisierungsbaugruppe eingesetzt.

In der DE 10 2012 022 746 A1 ist eine Automatisierungsbaugruppe für die industrielle Prozessautomatisierung offenbart, bei welcher zur Vermeidung von transienten elektromagnetischen Störungen ein Rastklemmteil für eine niederohmige Masseanbindung sorgt.

Es ist Aufgabe der vorliegenden Erfindung auf ein Metallgehäuse bei Automatisierungsbaugruppen zu verzichten und dennoch eine erhöhte Störfestigkeit gegen EMV-Störungen zu erreichen.

Für die eingangs genannte Automatisierungsbaugruppe wird die Aufgabe dadurch gelöst, dass das erste Befestigungsmittel eine Kombination aus einer Ausformung des Gehäuses und einer Integration eines elektrisch leitenden Schirmbleches ist, wobei das Gehäuse als ein Spritzgussteil und das Schirmblech als ein Stanzbiegeteil ausgestaltet ist und das Stanzbiegeteil derart umspritzt ist, dass eine das Schirmblech aufweisende Fläche für eine Masseanbindung der Datenanschlüsse und der Leiterplatte derart zur Außenseite des Gehäuses gerichtet ist, dass ein durch eine in dem ersten Befestigungsmittel angeordnete Ausnehmung geführtes elektrisch leitendes Gegenbefestigungsmittel mit der Fläche einen elektrischen Kontakt eingeht, wobei das Schirmblech eine erste ringförmige Öffnung und eine zweite ringförmige Öffnung aufweist, in die erste ringförmige Öffnung für den ersten Datenanschluss ein elektrisch leitender erster zylindrischer Befestigungseinsatz und in die zweite ringförmige Öffnung für den zweiten Datenanschluss ein elektrisch leitender zweiter zylindrischer Befestigungseinsatz derart eingepresst ist, dass ein elektrischer Kontakt zwischen den ringförmigen Öffnungen und den Befestigungseinsätzen entsteht. Das Gegenbefestigungsmittel kann beispielsweise eine metallische Schraube sein, welche durch das Loch des ersten Befestigungsmittels durchgesteckt wird, der Kopf der metallischen Schraube liegt somit auf der Fläche auf und geht mit der Fläche wiederum einen elektrischen Kontakt ein, wobei die metallische Schraube, beispielsweise mit einer Mutter in einem Schaltschrank oder auf einer metallischen Montageschiene verschraubt wird. Durch die Verschraubung wird erreicht, dass die Baugruppe mit ihrem Schirmblech eine gute Masseverbindung mit einer Funktionserde, wie sie z.B. bei einem Schaltschrank oder bei einer Montageschiene vorgesehen ist, erreicht.

Mit Vorteil hat man mit dieser Ausgestaltungsvariante eine hinsichtlich der Fertigung günstigere Baugruppe erfunden, denn das Gehäuse muss nicht mehr komplett aus Metall gefertigt sein, sondern wird in einem Kunststoffspritzgussverfahren gefertigt, wobei die empfindliche Stelle bei den Datenanschlüssen mit einem Schirmblech umgeben wird und das Schirmblech während des Spritzgussverfahrens umspritzt wird. Hinsichtlich einer Fertigung des Gehäuses der Automatisierungsbaugruppe ist das Gehäuse bereits mit dem Kunststoffspritzverfahren hergestellt worden, dabei wurde das Schirmblech in das Gehäuse mit eingespritzt. Für den ersten und den zweiten Datenanschluss weist das Gehäuse entsprechende Löcher auf. Durch diese Löcher werden bei einer Fertigung der Automatisierungsbaugruppe die zylindrischen Befestigungseinsätze in die ringförmigen Öffnungen eingepresst. Das Schirmblech mit seinen ringförmigen Öffnungen und dem elektrischen Kontakt von den ringförmigen Öffnungen zu den Befestigungseinsätzen bildet nun für die Datenanschlüsse einen geschlossenen EMV-Schirm, für die Datenanschlüsse.

Für eine erhöhte Festigkeit und einen sicheren Kontakt zwischen den zylindrischen Befestigungseinsätzen und den ringförmigen Öffnungen weisen die Zylinder an einem ersten Ende eine Riffelung und an ihrem zweiten Ende einen Kragen auf. Die Riffelung sitzt nach einem Einpressvorgang in den ringförmigen Öffnungen innerhalb des Ringes der ringförmigen Öffnungen. Der Kragen liegt vorzugsweise später auf einer Gehäuseoberfläche des aus Kunststoff gespritzten Gehäuses auf.

Insbesondere bei Automatisierungsbaugruppen, welche eine erhöhte Festigkeit gegen Feuchtigkeit aufweisen müssen, beispielsweise IP 67 bzw. Dichtheit gegen zeitweiliges Untertauchen, ist es von Vorteil wenn die Zylinder auf ihrer Mantelfläche eine umlaufende Dichtlippe aufweisen. Die umlaufende Dichtlippe geht mit dem Kunststoff gespritzten Gehäuse eine dichte Verbindung ein.

In einer besonders vorteilhaften Ausgestaltung ist das Schirmblech als ein u-förmiges Hauptteil mit einem ersten Schenkel, einem zweiten Schenkel und einem Mittelteil ausgestaltet, der erste Schenkel und der zweite Schenkel weisen jeweils ein Stanzloch auf, welche zum Durchführen des Befestigungsmittels deckungsgleich gegenüberliegend angeordnet sind zum Befestigen der Baugruppe in einer Seitenlage.

Für eine alternative Befestigung der Automatisierungsbaugruppe weist das Mittelteil ein weiteres Stanzloch zum Durchführen des Gegenbefestigungsmittels auf zum Befestigen in einer Rückenlage der Baugruppe, welche eine um 90-Grad gedrehte Lage zur Seitenlage entspricht.

Eine weitere verfeinerte Ausgestaltung des Schirmbleches ist derart ausgestaltet, dass an dem u-förmigen Hauptteil zumindest ein Verbindungssteg zu der ersten ringförmigen Öffnung und der zweiten ringförmigen Öffnung angeordnet ist.

In einer vorteilhaften Ausgestaltung insbesondere zur Befestigung von Rundsteckverbindern sind die zylindrischen Befestigungseinsätze als ein Metallgewindeeinsatz für schraubbare Rundsteckverbinder ausgestaltet.

Für eine Verbesserung hinsichtlich der Fertigung und der EMV Störfestigkeit sind die zylindrischen Befestigungseinsätze mit dem Schirmblech als ein geschlossener EMV-Schirm im Bereich der Datenanschlüsse ausgestaltet und gleichzeitig verstärkt der EMV-Schirm oder bildet der EMV-Schirm das Befestigungsmittel.

Um letztendlich die Leiterplatte des Automatisierungsgerätes ebenfalls mit dem Schirmblech zu verbinden, kontaktiert das Schirmblech über einen Verbindungssteg einen Masselayer der Leiterplatte.

Weitere Ausgestaltungsmerkmale werden in der Zeichnung offenbart. Es zeigt
- FIG 1: eine Automatisierungsbaugruppe mit Datenanschlüssen und mehreren Ein-/Ausgabeanschlüssen sowie einem ersten und einem zweiten Befestigungsmittel zum Anschrauben an eine Montageschiene oder zum Einschrauben in einen Schaltschrank,
- FIG 2: die in FIG 1 gezeigte Automatisierungsbaugruppe mit abgenommenen Gehäuse,
- FIG 3: eine Detaildarstellung eines Schirmbleches für die Datenanschlüsse der Automatisierungsbaugruppe und
- FIG 4: eine weitere Detaildarstellung der Darstellung aus FIG 3, wobei nur das Schirmblech mit zylindrischen Befestigungseinsätzen zum Unterdrücken der EMV Störungen gezeigt ist.

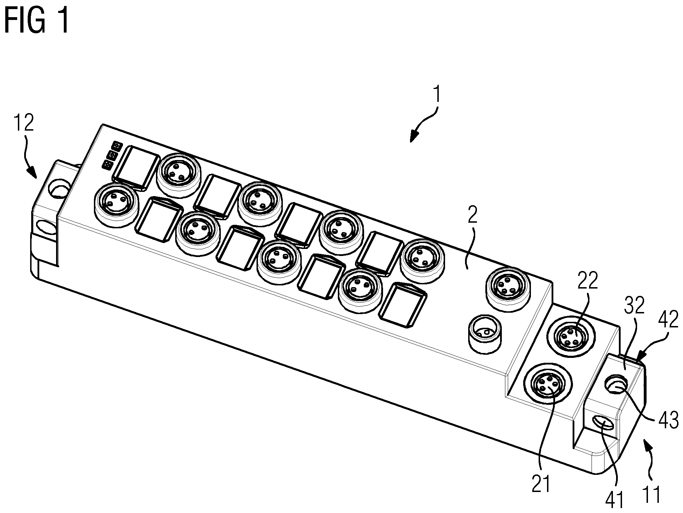

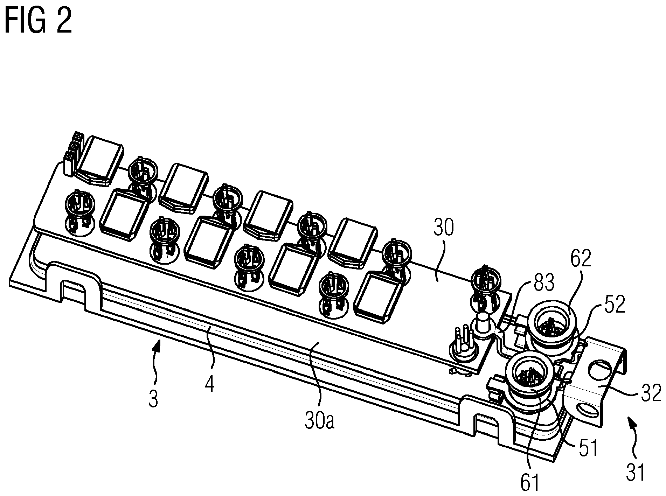

Gemäß der FIG 1 ist eine Automatisierungsbaugruppe 1 für die industrielle Prozessautomatisierung dargestellt. Derartige Automatisierungsbaugruppen werden vorzugsweise als eine dezentrale Peripherie eingesetzt. Die Automatisierungsbaugruppe 1 umfasst ein Gehäuse 2 mit einem ersten integrierten Befestigungsmittel 11 und einem zweiten integrierten Befestigungsmittel 12, welche gegenüberliegend angeordnet sind. Für eine Datenkommunikation der Automatisierungsbaugruppe 1 mit anderen Automatisierungsbaugruppen oder mit einem übergeordneten Automatisierungsgerät weist die Automatisierungsbaugruppe 1 einen ersten Datenanschluss 21 und einen zweiten Datenanschluss 22 auf. Für die Verarbeitung möglicher Eingangs- und Ausgangssignale hat die Automatisierungsbaugruppe weitere Eingänge für Prozesssignale, welche über eine im Inneren der Automatisierungsbaugruppe 1 angeordnete elektronische Leiterplatte 30 (siehe FIG 2) ausgewertet und verarbeitet werden. Hinsichtlich einer Montagefreundlichkeit sind der erste Datenanschluss 21 und der zweite Datenanschluss 22 im Bereich des ersten Befestigungsmittels 11 angeordnet.

Im Bezug auf die Montage der Automatisierungsbaugruppe 1 mit einem Gegenbefestigungsmittel, beispielsweise der Montage im einen Schaltschrank oder an einer metallischen Montageschiene ist das erste Befestigungsmittel 11 als eine Kombination aus einer Ausformung des Gehäuses 2 und einer Integration eines elektrisch leitenden Schirmbleches 31 (siehe FIG 2 bis 4) ausgestaltet. Das Gehäuse 2 ist dabei als ein Spritzgussteil und das Schirmblech 31 als ein Stanzbiegeteil ausgestaltet. Das Stanzbiegeteil ist derart umspritzt, dass eine das Schirmblech 31 aufweisende Fläche 32 für eine Masseanbindung der Datenanschlüsse 21,22 und der Leiterplatte 30 derart zur Außenseite des Gehäuses 2 gerichtet ist, dass ein durch eine in dem ersten Befestigungsmittel 11 angeordnete Ausnehmung, wobei die Ausnehmung eine erste Ausnehmung 41, eine zweite Ausnehmung 42 oder eine dritte Ausnehmung 43 sein kann, geführtes elektrisch leitendes Gegenbefestigungsmittel mit der Fläche 32 einen elektrischen Kontakt eingeht.

Üblicherweise wurden bisher teure Metallgehäuse verwendet, um eine Schirmanbindung von Datenanschlüssen mit einer Flachbaugruppe, insbesondere eine elektronische Leiterplatte, zu realisieren.

Mit der FIG 2 ist die aus FIG 1 bekannte Automatisierungsbaugruppe in einer geöffneten Darstellung mit einem abgehobenen Gehäuse 2 dargestellt.

Das Schirmblech 31 weist eine erste ringförmige Öffnung 51 und eine zweite ringförmige Öffnung 52 auf, in die erste ringförmige Öffnung 51 ist für den ersten Datenanschluss 21 ein elektrisch leitender erster zylindrischer Befestigungseinsatz 61 und in die zweite ringförmige Öffnung 51 ist für den zweiten Datenanschluss 22 ein elektrisch leitender zweiter zylindrischer Befestigungseinsatz 62 derart eingepresst, dass ein elektrischer Kontakt zwischen den ringförmigen Öffnungen 51,52 und den Befestigungseinsätzen 61,62 entsteht.

Das Schirmblech 31 ist sowohl mit den zylindrischen Befestigungseinsätzen 61,62 als auch mit der Leiterplatte 30 elektrisch verbunden. Ein dritter Verbindungssteg 83 führt von dem Schirmblech 31 zur Leiterplatte 30, wobei durch eine Schraubverbindung eine Öse des dritten Verbindungssteges 83 mit der Leiterplatte 30 verschraubt ist. Das Schirmblech 31 kontaktiert über den dritten Verbindungssteg 83 einen Masselayer der Leiterplatte 30. Diese Massekontaktierung wird über die Leiterplatte 30 an eine zweite Leiterplatte 30a über einen verdeckten Steckverbinder weitergegeben.

Für eine Dichtheit bei aufgesetzten Gehäuse 2 weist die Automatisierungsbaugruppe 1 einen Deckel 3 und eine Dichtung 4 auf.

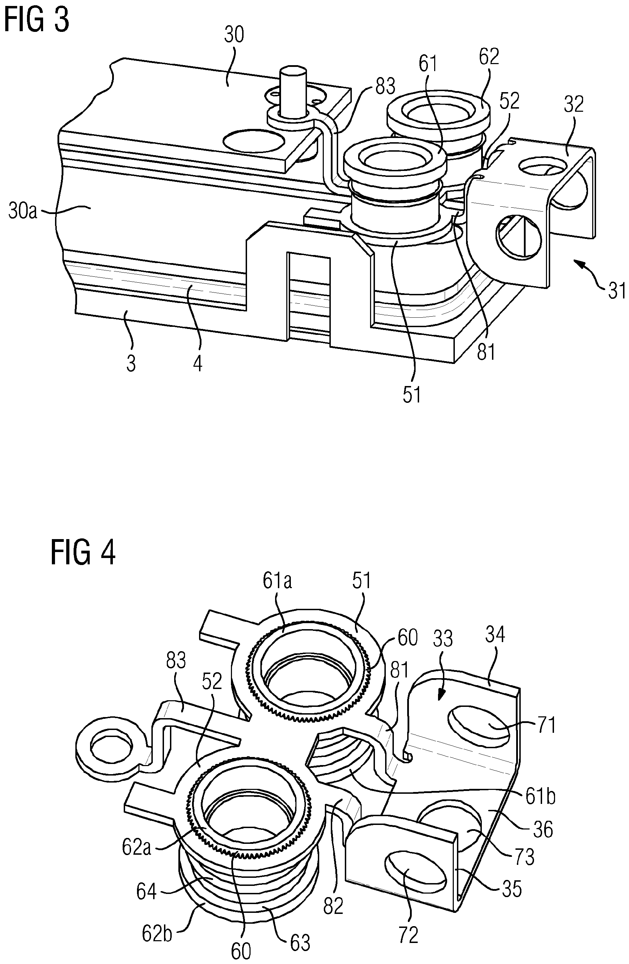

Die FIG 3 zeigt das Schirmblech 31 und die zylindrischen Befestigungseinsätze 61,62 in einer Detaildarstellung. Die zylindrischen Befestigungseinsätze 61,62 bilden mit dem Schirmblech 31 im Bereich der Datenanschlüsse 21,22 einen geschlossenen EMV-Schirm und gleichzeitig bildet dieser geschlossene EMV-Schirm als eine Kombination aus Schirmblech 31 als Stanzbiegeteil und zylindrischen Befestigungseinsätzen 61,62 eine Verstärkung für das erste Befestigungsmittel 11.

Das Schirmblech 31 bildet durch die Fläche 32 eine elektrische Kontaktfläche, welche bei dem erwähnten Spritzgussverfahren nicht mit Kunststoff beschichtet ist. Diese Fläche 32 wird als Kontaktfläche für, beispielsweise eine Schraube, verwendet. Die Schraube wird durch ein in das Schirmblech 31 eingearbeitetes Stanzloch, beispielsweise ein erstes Stanzloch 71, ein zweites Stanzloch 72 oder ein drittes Stanzloch 73 (siehe FIG 4) hindurch gesteckt. Der Kopf der Schraube geht mit dem Schirmblech 31 einen elektrischen Kontakt ein und kann somit durch die Montage der Automatisierungsbaugruppe beispielsweise an der metallischen Umhausung einer Maschine für eine funktionelle Masseanbindung sorgen.

Die FIG 4 zeigt im Detail das Schirmblech 31 mit den eingepressten zylindrischen metallischen Befestigungseinsätzen 61, 62.

Das Schirmblech 31 ist als ein u-förmiges Hauptteil 33 mit einem ersten Schenkel 34 und einem zweiten Schenkel 35 und einem Mittelteil 36 ausgestaltet. Der erste Schenkel 34 und der zweite Schenkel 35 weisen jeweils ein Stanzloch 71,72 auf, welche zum Durchführen des Gegenbefestigungsmittels deckungsgleich gegenüberliegend angeordnet sind und zum Befestigen der Baugruppe in einer Seitenlage dient.

Wird die Automatisierungsbaugruppe 1 in einer Rückenlage montiert, so ist in dem Mittelteil 36 ein weiteres drittes Stanzloch 73 zum Durchführen des Gegenbefestigungsmittels angeordnet. Wird die Automatisierungsbaugruppe 1 durch Durchstecken des Gegenbefestigungsmittels durch das dritte Stanzloch befestigt, so wird die Automatisierungsbaugruppe 1 in einer Rückenlage befestigt, welche eine um 90-Grad gedrehten Lage zur Seitenlage entspricht.

An dem u-förmigen Hauptteil 33 ist ein erster Verbindungssteg 81 und ein zweiter Verbindungssteg 82 angeordnet. Die Verbindungsstege 81,82 verbinden den Mittelteil 36 des Schirmbleches 31 jeweils mit der ersten ringförmigen Öffnung 51 und der zweiten ringförmigen Öffnung 52. In die erste ringförmige Öffnung 51 ist für den ersten Datenanschluss 21 der elektrisch leitende erste zylindrische Befestigungseinsatz 61 eingepresst und in die zweite Öffnung 52 ist für den zweiten Datenanschluss 22 der elektrisch leitende zweite zylindrische Befestigungseinsatz 62 eingepresst. Die Einpressung erfolgt durch das bereits fertig gespritzte Gehäuse, wobei das Schirmblech 31 im fertig gespritzten Gehäuse umspritzt wurde und als integrativer Bestandteil des Gehäuses besteht. Die zylindrischen Befestigungseinsätze 61,62 sind derart in die ringförmigen Öffnungen 51,52 eingepresst, dass ein elektrischer Kontakt zwischen den ringförmigen Öffnungen 51,52 und dem Befestigungseinsätzen 61,62 entsteht. Um den elektrischen Kontakt und den Einpressvorgang zu verbessern, weisen die Zylinder an ihrem ersten Ende 61a eine Riffelung 60 und an ihrem zweiten Ende 61b einen Kragen 63 auf.

Die ringförmigen Öffnungen 51,52 sind weiter über einen dritten Verbindungssteg 83 an einen Masselayer der Leiterplatte 30 (siehe FIG 3) anschließbar. Damit entsteht durch die zylindrischen Befestigungseinsätze 61,62 in Kombination mit dem Schirmblech 31 ein geschlossener EMV-Schirm im Bereich der Datenanschlüsse 21,22 und gleichzeitig bildet das Schirmblech 31 ein verstärktes Befestigungsmittel 11.

## Patentansprüche

1. Automatisierungsbaugruppe (1) für die industrielle Prozessautomatisierung, umfassend
ein Gehäuse (2) mit einem ersten integrierten Befestigungsmittel (11),
einen ersten Datenanschluss (21),
einen zweiten Datenanschluss (22),
eine elektronische Leiterplatte (30),
wobei der erste Datenanschluss (21) und der zweite Datenanschluss (22) im Bereich des ersten Befestigungsmittels (11) angeordnet sind,
**dadurch gekennzeichnet, dass** das Gehäuse ein zweites integriertes Befestigungsmittel (12) aufweist, welches dem ersten Befestigungsmittel (11) gegenüberliegend angeordnet ist, und dass das erste Befestigungsmittel (11) eine Kombination aus einer Ausformung des Gehäuses (2) und einer Integration eines elektrisch leitenden Schirmbleches (31) ist, wobei das Gehäuse (2) als ein Spritzgussteil und das Schirmblech (31) als ein Stanzbiegeteil ausgestaltet ist und das Stanzbiegeteil derart umspritzt ist, dass eine das Schirmblech (31) aufweisende Fläche (32) für eine Masseanbindung der Datenanschlüsse (21,22) und der Leiterplatte (30) derart zur Außenseite des Gehäuses (2) gerichtet ist, dass ein durch eine in dem ersten Befestigungsmittel (11) angeordnete Ausnehmung (41,42,43) geführtes elektrisch leitendes Gegenbefestigungsmittel mit der Fläche (32) einen elektrischen Kontakt eingeht, wobei das Schirmblech (31) eine erste ringförmige Öffnung (51) und eine zweite ringförmige Öffnung (52) aufweist, in die erste ringförmige Öffnung (51) für den ersten Datenanschluss (21) ein elektrisch leitender erster zylindrischer Befestigungseinsatz (61) und in die zweite ringförmige Öffnung (52) für den zweiten Datenanschluss (22) ein elektrisch leitender zweiter zylindrischer Befestigungseinsatz (62) derart eingepresst ist, dass ein elektrischer Kontakt zwischen den ringförmigen Öffnungen (51,52) und den Befestigungseinsätzen (61,62) entsteht.

2. Automatisierungsbaugruppe (1) nach Anspruch 1, wobei die Zylinder an einem ersten Ende (61a) eine Riffelung (60) und an ihrem zweiten Ende (61b) einen Kragen (63) aufweisen.

3. Automatisierungsbaugruppe (1) nach Anspruch 1 oder 2, wobei die Zylinder (61,62) eine umlaufende Dichtlippe (64) aufweisen.

4. Automatisierungsbaugruppe (1) nach einem der Ansprüche 1 bis 3, wobei das Schirmblech (31) ein u-förmiges Hauptteil (33) mit einem ersten Schenkel (34), einem zweiten Schenkel (35) und einem Mittelteil (36) aufweist, der erste Schenkel (34) und der zweite Schenkel (35) weisen jeweils ein Stanzloch (71,72) auf, welche zum Durchführen des Gegenbefestigungsmittels deckungsgleich gegenüberliegend angeordnet sind zum Befestigen der Baugruppe in einer Seitenlage.

5. Automatisierungsbaugruppe (1) nach Anspruch 4, wobei das Mittelteil (36) ein weiteres Stanzloch (73) zum Durchführen des Gegenbefestigungsmittels aufweist zum Befestigen in einer Rückenlage der Baugruppe, welche eine um 90-Grad gedrehte Lage zur Seitenlage entspricht.

6. Automatisierungsbaugruppe (1) nach Anspruch 4 oder 5, wobei an dem u-förmigen Hauptteil (33) zumindest ein Verbindungssteg (81,82) zu der ersten ringförmigen Öffnung (51) und der zweiten ringförmigen Öffnung (52) angeordnet ist.

7. Automatisierungsbaugruppe (1) nach einem der Ansprüche 1 bis 6, wobei die zylindrischen Befestigungseinsätze (61,62) als ein Metallgewindeeinsatz für schraubbare Rundsteckverbinder ausgestaltet sind.

8. Automatisierungsbaugruppe (1) nach einem der Ansprüche 1 bis 7, wobei die zylindrischen Befestigungseinsätze (61,62) mit dem Schirmblech (31) zusammen als ein geschlossener EMV-Schirm im Bereich der Datenschlüsse (21,22) ausgestaltet sind und gleichzeitig der EMV-Schirm das Befestigungsmittel (11) verstärkt oder bildet.

9. Automatisierungsbaugruppe (1) nach einem der Ansprüche 1 bis 8, wobei das Schirmblech (31) über einen Verbindungssteg (83) einen Masselayer der Leiterplatte (30) kontaktiert.

## Claims

1. Automation assembly (1) for industrial process automation, comprising
a housing (2) with a first integrated attachment means (11),
a first data connector (21),
a second data connector (22),
an electronic printed circuit board (30),
wherein the first data connector (21) and the second data connector (22) are arranged in the vicinity of the first attachment means (11),
**characterised in that**
the housing has a second integrated attachment means (12) arranged opposite the first attachment means (11), and **in that** the first attachment means (11) is a combination of a moulding of the housing (2) and an integration of an electrically conductive shielding sheet (31), wherein the housing (2) is embodied as an injection-moulded part and the shielding sheet (31) is embodied as a stamped bent part, and the stamped bent part is extrusion-coated such that a surface (32) having the shielding sheet (31) for earthing the data connectors (21, 22) and the printed circuit board (30) is directed toward the outer face of the housing (2) such that an electrically conductive counter-attachment means guided through a cut-out (41, 42, 43) arranged in the first attachment means (11) forms an electrical contact with the surface (32), wherein the shielding sheet (31) has a first annular opening (51) and a second annular opening (52), into which first annular opening (51) an electrically conductive first cylindrical attachment insert (61) for the first data connector (21) and into which second annular opening (52) an electrically conductive second cylindrical attachment insert (62) for the second data connector (22) are press-fitted
such that an electrical contact between the annular openings (51, 52) and the attachment inserts (61, 62) is created.

2. Automation assembly (1) according to claim 1, wherein the cylinders have at a first end (61a) a corrugation (60) and at their second end (61b) a collar (63).

3. Automation assembly (1) according to claim 1 or 2, wherein the cylinders (61, 62) have a circumferential sealing lip (64).

4. Automation assembly (1) according to one of claims 1 to 3, wherein the shielding sheet (31) has a u-shaped main section (33) with a first blade (34), a second blade (35) and a central section (36), said first blade (34) and second blade (35) each having a stamped hole (71, 72) which, for guiding through the counter-attachment means, are arranged opposite and congruently with one another for attaching the assembly in a lateral position.

5. Automation assembly (1) according to claim 4, wherein the central section (36) has a further stamped hole (73) for guiding through the counter-attachment means for attaching in an upside-down position of the assembly, which corresponds to a position rotated about 90 degrees relative to the lateral position.

6. Automation assembly (1) according to claim 4 or 5, wherein at least one connection bridge (81, 82) to the first annular opening (51) and the second annular opening (52) is arranged on the u-shaped main section (33).

7. Automation assembly (1) according to one of claims 1 to 6, wherein the cylindrical attachment inserts (61, 62) are embodied as a threaded metal insert for round screw-on connectors.

8. Automation assembly (1) according to one of claims 1 to 7, wherein the cylindrical attachment inserts (61, 62) are embodied together with the shielding sheet (31) as a closed EMC shield in the vicinity of the data connectors (21, 22) and the EMC shield simultaneously strengthens or forms the attachment means (11).

9. Automation assembly (1) according to one of claims 1 to 8, wherein the shielding sheet (31) contacts an earth layer of the printed circuit board (30) by means of a connection bridge (83).

## Revendications

1. Bloc (1) d'automatisation pour l'automatisation de processus industriel, comprenant
un boîtier (2) ayant un premier moyen (11) de fixation intégré,
une première borne (21) de données,
une deuxième borne (22) de données,
une plaquette (30) électronique à circuit imprimé,
dans lequel la première borne (21) de données et la deuxième borne (22) de données sont disposées dans la région du premier moyen (11) de fixation,
**caractérisé en ce que**
le boîtier a un deuxième moyen (12) de fixation intégré, qui est disposé à l'opposé du premier moyen (11) de fixation et **en ce que**
le premier moyen (11) de fixation est une combinaison d'une déformation du boîtier (2) et d'une intégration d'une tôle (31) formant écran conductrice de l'électricité, le boîtier (2) étant sous la forme d'une pièce moulée par injection et la tôle (31) formant écran sous la forme d'une pièce estampée pliée et la pièce estampée pliée étant recouverte par extrusion, **en ce qu'**une surface (32), ayant la tôle (31) formant écran, est, pour une liaison à la masse des bornes (21, 22) de données et de la plaquette (30) à circuit imprimé, dirigée vers le côté extérieur du boîtier (2) de manière à ce qu'un moyen de fixation antagoniste, conducteur de l'électricité et passant dans un évidement (41, 42, 43) du premier moyen (11) de fixation, entre en contact électrique avec la surface (32), la tôle (31) formant écran ayant une première ouverture (51) annulaire et une deuxième ouverture (52) annulaire, un premier insert (61) de fixation cylindrique et conducteur de l'électricité étant pressé dans la première ouverture (51) annulaire pour la première borne (21) de données et un deuxième insert (62) de fixation cylindrique et conducteur de l'électricité dans la deuxième ouverture (52) annulaire pour la deuxième borne (22) de données, de manière
à créer un contact électrique entre les ouvertures (51, 52) annulaires et les inserts (61, 62) de fixation.

2. Bloc (1) d'automatisation suivant la revendication 1, dans lequel les cylindres ont, à une première extrémité (61a), un moletage (60), et à leur deuxième extrémité (61b), un collet (63).

3. Bloc (1) d'automatisation suivant la revendication 1 ou 2, dans lequel les cylindres (61, 62) ont une lèvre (64) d'étanchéité faisant le tour.

4. Bloc (1) d'automatisation suivant l'une des revendications 1 ou 2, dans lequel la tôle (31) formant écran a une partie (33) principale en forme de u ayant une première branche (34), une deuxième branche (35) et une partie (36) médiane, la première branche (34) et la deuxième branche (( 35) ont chacune un trou (71, 72) estampé, qui sont disposés de manière opposée en coïncidence pour le passage du moyen de fixation antagoniste, afin de fixer le bloc dans une position latérale.

5. Bloc (1) d'automatisation suivant la revendication 4, dans lequel la partie (36) médiane a un autre trou (73) estampé pour le passage du moyen de fixation antagoniste, afin de fixer, dans une position arrière, le bloc, qui correspond à une position à 90° par rapport à la position latérale.

6. Bloc (1) d'automatisation suivant la revendication 4 ou 5, dans lequel, sur la partie (33) principale en forme de u est disposée au moins une barrette (81, 82) de liaison allant vers la première ouverture (51) annulaire et la deuxième ouverture (52) annulaire.

7. Bloc (1) d'automatisation suivant l'une des revendications 1 à 6, dans lequel les inserts (61, 62) de fixation cylindriques sont sous la forme d'inserts filetés métalliques pour des connecteurs à enfichage circulaire vissables.

8. Bloc (1) d'automatisation suivant l'une des revendications 1 à 7, dans lequel les inserts (61, 62) de fixation cylindriques sont conformés, ensemble avec la tôle (31) formant écran, sous la forme d'un écran EMV fermé dans la région des bornes (21, 22) de données et en même temps l'écran EMV renforce ou forme le moyen (11) de fixation.

9. Bloc (1) d'automatisation suivant l'une des revendications 1 à 8, dans lequel la tôle (31) formant écran est mise en contact avec une couche de masse de la plaquette (30) à circuit imprimé par une barrette (83) de liaison.
